# EUROPÄISCHE PATENTSCHRIFT

(11) **EP 2 599 137 B1**
(45) Veröffentlichungstag und Bekanntmachung des Hinweises auf die Patenterteilung: **20.07.2016**
(21) Anmeldenummer: 11741180.1
(22) Anmeldetag: 29.07.2011
(51) Int. Cl.: H01L 41/047, H01L 41/083

(54) **PIEZOELEKTRISCHER VIELSCHICHTAKTOR**
PIEZOELECTRIC MULTILAYER ACTUATOR
ACTIONNEUR PIÉZOÉLECTRIQUE MULTICOUCHE

(30) Priorität: 26.10.2010 DE 102010049574; 30.07.2010 DE 102010032810
(43) Veröffentlichungstag der Anmeldung: 05.06.2013
(73) Patentinhaber: Epcos AG, 81669 München (DE)
(72) Erfinder: GABL, Reinhard, 6330 Kufstein (AT); GALLER, Martin, 8401 Kalsdorf (AT); STANI, Andreas, 8430 Leibnitz (AT); OTTLINGER, Marion, 8530 Deutschlandsberg (AT)
(74) Vertreter: Epping - Hermann - Fischer
(86) Internationale Anmeldenummer: PCT/EP2011/063123
(87) Internationale Veröffentlichungsnummer: WO 2012/013788

(56) Entgegenhaltungen:
- WO-A1-2010/101056
- DE-A1- 19 930 585
- JP-A- 2001 210 884

## Beschreibung

Es wird ein piezoelektrischer Vielschichtaktor mit einem Stapel aus piezoelektrischen Schichten und dazwischen angeordneten Elektrodenschichten angegeben.

In der Druckschrift DE 10 2006 026 643 A1 ist ein piezoelektrischer Aktor beschrieben.

DE 199 30 585 A1 offenbart einen piezoelektrischen Vielschichtaktor mit elektrischen Kontaktelementen, die ein Drahtgewebe aus Edelstahl in Köperbindung aufweisen.

Eine Aufgabe zumindest einiger Ausführungsformen ist es, einen piezoelektrischen Vielschichtaktor mit einem Kontaktelement anzugeben, welches eine möglichst zuverlässige und kostengünstige elektrische Kontaktierung erlaubt.

Diese Aufgabe wird durch einen Gegenstand mit den Merkmalen des unabhängigen Patentanspruchs gelöst. Vorteilhafte Ausführungsformen und Weiterbildungen des Gegenstands gehen weiterhin aus der nachfolgenden Beschreibung und den Zeichnungen hervor.

Ein piezoelektrischer Vielschichtaktor gemäß zumindest einer Ausführungsform weist insbesondere einen Stapel aus übereinander angeordneten piezoelektrischen Schichten und dazwischen abwechselnd übereinander angeordneten ersten Elektrodenschichten und zweiten Elektrodenschichten auf, die sich von einer ersten und einer zweiten Seitenfläche des Stapels in den Stapel hineinerstrecken und sich im Stapel überlappen. Weiterhin sind auf der ersten Seitenfläche ein erstes Kontaktelement in elektrischem Kontakt mit den ersten Elektrodenschichten und auf der zweiten Seitenfläche ein zweites Kontaktelement in elektrischem Kontakt mit den zweiten Elektrodenschichten angeordnet.

Bei der Herstellung eines zuverlässigen elektrischen Kontakts zwischen den als Innenelektroden ausgebildeten Elektrodenschichten von piezoelektrischen Vielschichtaktoren und den Elektroden eines elektrischen Ansteuergeräts liegen die technischen Schwierigkeiten unter anderem darin, dass die Kontaktierung in Form des ersten und zweiten Kontaktelements durch die oftmalige Auslenkung des piezoelektrischen Vielschichtaktors, das heißt typischerweise mehr als 10⁹ Auslenkungen beispielsweise bei Anwendung des piezoelektrischen Vielschichtaktors in Einspritzsystemen von Motoren, nicht beschädigt werden soll und die Kontaktierung möglichst geringen Einfluss auf die Bewegungen des piezoelektrischen Vielschichtaktors nehmen soll. Das Problem der Realisierung einer zuverlässigen Kontaktierung wird besonders durch hohe Dehnungen, die im Nahbereich von Rissen in den piezoelektrischen Vielschichtaktoren auftreten, verschärft. Zusätzlich bestehen je nach Einsatzzweck mitunter hohe Anforderung für die Kontaktierung hinsichtlich der Temperaturstabilität, der Vermeidung von Verschmutzung und Vorschädigung des piezoelektrischen Vielschichtaktors durch das Anbringen der Kontaktierung sowie hinsichtlich geringer Kosten für Material und Prozess. In vielen Anwendungen kann weiterhin eine schlanke, also platzsparende, Bauform der Kontaktierung notwendig beziehungsweise von Vorteil sein.

Zur externen Kontaktierung eines Vielschicht-Piezoaktors gibt es eine große Zahl unterschiedlicher technologischer Konzepte. Ein typisches Konzept liegt beispielsweise darin, eine so genannte Drahtharfe mittels Weichlötung auf der Außenmetallisierung zu befestigen. Diese Kontaktierungsart ist jedoch auf nachteilige Weise mit einem hohen Platzbedarf und einer Verschmutzung mit Flussmittel verbunden. Des Weiteren sind Lotkontaktierungen bekannt, die ganz speziellen Designvorgaben hinsichtlich Material, Aufbau (z.B. Pin an Drahtharfe, Sieb oder Blech), Geometrie oder ähnlichem genügen sollen. Darüber hinaus sind beispielsweise auch Schweißkontaktierungen bekannt.

Gemäß einer besonders bevorzugten Ausführungsform des hier beschriebenen piezoelektrischen Vielschichtaktors weisen die Kontaktelemente jeweils ein Drahtgewebe auf. Hier und im Folgenden kann das Drahtgewebe auch als Drahtgeflecht bezeichnet werden.

Gemäß einer weiteren Ausführungsform weisen das erste und zweite Kontaktelement durch das jeweilige Drahtgewebe einen flexiblen Aufbau der Kontaktierung der ersten und zweiten Elektrodenschichten auf.

Die Anordnung des ersten und zweiten Kontaktelements auf dem Stapel der piezoelektrischen Schichten kann dabei beispielsweise mittels Anlöten erfolgen. Beispielsweise kann auf der ersten und zweiten Seitenfläche jeweils eine elektrische Kontaktschicht angeordnet sein, wobei das erste und das zweite Kontaktelement jeweils auf einer der elektrischen Kontaktschichten, etwa durch Löten, befestigt sind. Beispielsweise wird beim Aufbringen einer solchen elektrischen Kontaktschicht, die auch Grundmetallisierung genannt wird, eine Metallpaste auf die erste und zweite Seitenfläche gedruckt, anschließend getrocknet und zuletzt eingebrannt. Zum Auflöten der Kontaktelemente auf die Kontaktschichten kann ein Lot, zum Beispiel ein Kupfer-Zinn-Lot, verwendet werden.

Gemäß einer weiteren Ausführungsform ist ein Kontaktstift zur Weiterkontaktierung in zumindest eines oder jeweils in eines der beiden Drahtgewebe integriert. Beispielsweise wird ein solcher Kontaktstift, der beispielsweise auch durch einen Litzendraht, einen Pin oder ein Streckmetall gebildet sein kann, durch Löten oder Schweißen mit dem Drahtgewebe mechanisch und elektrisch verbunden. Vorzugsweise werden das erste beziehungsweise zweite Kontaktelement und der in das Drahtgewebe des Kontaktelements integrierte Kontaktstift in einem gemeinsamen Lötschritt auf den Stapel aus piezoelektrischen Schichten und dazwischen angeordneten Elektrodenschichten aufgebracht.

Gemäß einer weiteren Ausführungsform können die Kontaktelemente jeweils ein gewebtes oder geflochtenes Metallband oder einen gewebten oder geflochtenen Metalldraht aufweisen.

Die Erfinder haben herausgefunden, dass die Materialeigenschaften der Kontaktelemente, also die Eigenschaften des entsprechenden Gewebes des Drahtes entscheidend den Fehlermodus und die Lebensdauer des piezoelektrischen Vielschichtaktors bestimmen. Dies kann insbesondere für solche Aktoranwendungen gelten, die hohe Dehnungen erfordern. Weiterhin können mit Vorteil der thermische Ausdehnungskoeffizient und/oder der Elastizitätsmodul, auch als E-Modul bezeichnet, den entsprechenden Eigenschaften des Stapels der piezoelektrischen Schichten, der beispielsweise ein geeignetes piezoelektrisches Keramikmaterial aufweisen kann, angepasst sein.

Daneben können sich mit Vorteil Eigenschaften des ersten und zweiten Kontaktelements wie Zugfestigkeit, Bruchdehnung und Streckgrenze als wichtige Parameter erweisen. Darüber hinaus kann es beispielsweise auch möglich sein, dass die Lebensdauer des piezoelektrischen Vielschichtaktors im Vergleich zu bekannten Kontaktierungsmöglichkeiten bei unveränderter Drahtzusammensetzung allein schon durch die Art des Maschenverbundes vorteilhaft erhöht werden kann.

Erfindungsgemäß weist zumindest ein Drahtgewebe eine Köperbindung auf. Wird der Maschenverbund lockerer gewählt, beispielsweise durch eine Köperbindung anstatt einer Leinenbindung, kann es während der Drahtherstellung und bei Dehnung im Anwendungsbereich zu geringerer Drahtbelastung kommen. Gemäß einer weiteren Ausführungsform weist das zumindest eine Drahtgewebe einen Elastizitätsmodul von 200000 MPa auf. Gemäß einer weiteren Ausführungsform weist das zumindest eine Drahtgewebe eine Zugfestigkeit von größer oder gleich 500 N/mm² auf, wobei hier und im Folgenden die Grenzen von angegebenen Bereichen jeweils mit eingeschlossen sind. Bei verschiedenen Tests hinsichtlich der Zuverlässigkeit in der Anwendung von piezoelektrischen Vielschichtaktoren haben die Erfinder herausgefunden, dass durch die Verwendung von Drahtgeweben unter anderem mit einer Zugfestigkeit von größer oder gleich 500 N/mm² die Lebensdauer von Vielschichtaktoren im Vergleich zu Vielschichtaktoren, welche Kontaktelemente aus Drahtgeweben mit einer geringeren Zugfestigkeit aufweisen, signifikant erhöht werden kann.

Vorzugsweise weist das zumindest eine Drahtgewebe eine Zugfestigkeit von größer oder gleich 500 N/mm² und kleiner oder gleich 850 N/mm² auf.

In einer weiteren Ausführungsform weist das zumindest eine Drahtgewebe eine Zugfestigkeit von größer oder gleich 500 N/mm² und kleiner oder gleich 700 N/mm² auf. In einer weiteren Ausführungsform weisen die Drahtgewebe der Kontaktelemente eine Zugfestigkeit von größer oder gleich 650 N/mm² und kleiner oder gleich 850 N/mm² auf.

Gemäß einer weiteren Ausführungsform weist das zumindest eine Drahtgewebe eine Streckgrenze von größer oder gleich 380 N/mm² auf. In einer weiteren Ausführungsform weist das zumindest eine Drahtgewebe eine Streckgrenze von größer oder gleich 380 N/mm² und kleiner oder gleich 550 N/mm² auf.

Gemäß einer weiteren Ausführungsform weist das zumindest eine Drahtgewebe eine Bruchdehnung von größer oder gleich 20% auf. In verschiedenen Test hinsichtlich der Zuverlässigkeit der Kontaktierung eines piezoelektrischen Vielschichtaktors bei großer mechanischer Beanspruchung wurde gezeigt, dass Kontaktelemente aus Drahtgeweben, welche eine Bruchdehnung von größer oder gleich 20% aufweisen, besonders gute Ergebnisse erzielt haben.

In einer weiteren Ausführungsform weist das zumindest eine Drahtgewebe eine Bruchdehnung im Bereich von 30 bis 35% auf.

Gemäß einer weiteren Ausführungsform weist das zumindest eine Drahtgewebe einen thermischen Ausdehnungskoeffizienten von größer oder gleich 1,1·10⁻⁵ auf. Die Erfinder haben herausgefunden, dass durch die Verwendung von Drahtgeweben, welche unter anderem einen thermischen Ausdehnungskoeffizienten von größer oder gleich 1,1·10⁻⁵ aufweisen, die Ausfallanfälligkeit der Kontaktierung des piezoelektrischen Vielschichtaktors deutlich gesenkt werden kann.

In einer weiteren Ausführungsform weist das zumindest eine Drahtgewebe einen thermischen Ausdehnungskoeffizienten von größer oder gleich 1,1·10⁻⁵ und kleiner oder gleich 1,60·10⁻⁵ auf.

Gemäß einer weiteren Ausführungsform weist das zumindest eine Drahtgewebe eine Maschenweite von größer oder gleich 0,1 mm und kleiner oder gleich 0,3 mm auf. Als besonders vorteilhaft kann sich eine Maschenweite von größer oder gleich 0,15 mm und kleiner oder gleich 0,2 mm, beispielsweise von 0,18 mm, erweisen.

Gemäß einer weiteren Ausführungsform weist das zumindest eine Drahtgewebe eine Drahtstärke von größer oder gleich 0,03 mm und kleiner oder gleich 0,3 mm, bevorzugt von größer oder gleich 0,02 und kleiner oder gleich 0,1, auf. Als besonders vorteilhaft kann sich beispielsweise eine Drahtstärke von 0,056 mm oder 0,080 mm erweisen.

Gemäß einer weiteren Ausführungsform liegt das Verhältnis von Drahtstärke zu Maschenweite des zumindest einen Drahtgewebes in einem Bereich zwischen 0,3 und 0,45. Es hat sich herausgestellt, dass Drahtgewebe, bei welchen das Verhältnis Drahtstärke zu Maschenweite in dem oben genannten Bereich liegt, bei Anwendung des piezoelektrischen Vielschichtaktors eine besonders geringe Drahtbelastung aufweisen. Vorzugsweise liegt der Abstand jeweils zweier direkt zueinander benachbarter erster oder jeweils zweier direkt zueinander benachbarter zweiter Elektrodenschichten im Stapel des piezoelektrischen Vielschichtaktors in einem Bereich von 60 bis 65 µm und besonders bevorzugt bei 62 µm.
Gemäß einer weiteren Ausführungsform liegt das Verhältnis der Maschenweite zu einem Abstand jeweils zweier direkt zueinander benachbarter erster oder jeweils zweier direkt zueinander benachbarter zweiter Elektrodenschichten in einem Bereich zwischen 2,5 und 3,5. Dadurch kann einerseits ein flexibler Aufbau der Kontaktelemente und andererseits eine zuverlässige Kontaktierung des piezoelektrischen Vielschichtaktors erreicht werden.

Erfindungsgemäß weist das zumindest eine Drahtgewebe eine NickelChrom-Legierung mit einem Verhältnis von Nickel zu Chrom von 80 zu 20 auf.

Gemäß einer weiteren Ausführungsform weisen die Drahtgewebe des ersten und zweiten Kontaktelements gleiche Merkmale und/oder Kombinationen gleicher Merkmale der vorgenannten Ausführungsformen auf. Vorzugsweise sind das erste und das zweite Kontaktelement gleich ausgeführt.

Der hier beschriebene piezoelektrische Vielschichtaktor weist mit Vorteil einen speziellen und flexiblen Aufbau der Kontaktierung für piezoelektrische Vielschichtaktoren auf, der mit Vorteil Relativbewegungen, beispielsweise lokale Relativbewegungen, zwischen dem piezoelektrischen Vielschichtaktor und den Bauteilen der Weiterkontaktierung ermöglicht. So kann es möglich sein, das Problem großer mechanischer Beanspruchung der Kontaktierung durch große axiale Dehnung des piezoelektrischen Vielschichtaktors durch Materialeigenschaften des Drahtes wie etwa Erhöhung der Streckgrenze und/oder Zugfestigkeit sowie alternativ oder zusätzlich durch einen lockeren Maschenverbund effektiv und technisch einfach realisierbar zu lösen.

Weitere Vorteile und vorteilhafte Ausführungsformen des angegebenen piezoelektrischen Vielschichtaktors ergeben sich aus den im Folgenden in Verbindung mit den Figuren 1 bis 4 beschriebenen Ausführungsformen.

Es zeigen:
Figur 1 eine schematische Ansicht eines piezoelektrischen Vielschichtaktors gemäß einem Ausführungsbeispiel,
Figur 2 ein Kraft-Dehnungsdiagramm für verschiedene Drahtgewebe,
Figuren 3 und 4 jeweils einen Stapel aus piezoelektrischen Schichten und dazwischen angeordneten Elektroden.

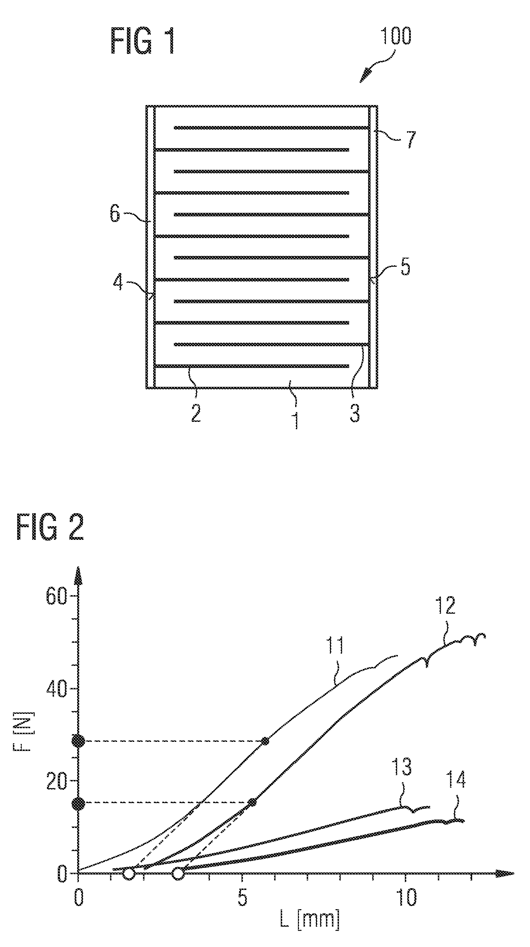

In Figur 1 ist ein piezoelektrischer Vielschichtaktor 100 gemäß einem Ausführungsbeispiel gezeigt, der einen Stapel 1 aus übereinander angeordneten piezoelektrischen Schichten und dazwischen abwechselnd übereinander angeordneten ersten Elektrodenschichten 2 und zweiten Elektrodenschichten 3 aufweist. Die ersten und zweiten Elektrodenschichten 2, 3 erstrecken sich von einer ersten Seitenfläche 4 und einer zweiten Seitenfläche 5 des Stapels 1 in den Stapel 1 hinein und überlappen sich im Stapel 1. Auf der ersten Seitenfläche 4 des Stapels 2 ist ein erstes Kontaktelement 6 in elektrischem Kontakt mit den ersten Elektrodenschichten 2 und auf der zweiten Seitenfläche 5 des Stapels 2 ein zweites Kontaktelement 7 in elektrischem Kontakt mit den zweiten Elektrodenschichten 3 angeordnet. Die Kontaktelemente 6, 7 weisen jeweils ein Drahtgewebe auf.

Die beiden Kontaktelemente 6, 7 können jeweils auf einer Kontaktschicht (nicht gezeigt), die auf die erste und zweite Seitenfläche 4, 5 des Stapels 2 gedruckt ist, befestigt werden. Die Kontaktschichten werden dabei beispielsweise in Form einer Metallpaste auf die Seitenflächen 4, 5 des Stapels 2 aufgebracht, anschließend getrocknet und dann eingebrannt. Die Befestigung der Kontaktelemente 6, 7 auf der Kontaktschicht erfolgt bevorzugt durch Auflöten.

Des Weiteren kann ein Kontaktstift (nicht gezeigt) zur Weiterkontaktierung in zumindest eines der beiden Drahtgewebe, besonders bevorzugt jeweils ein Kontaktstift in beide Drahtgewebe, integriert sein. Beispielsweise wird ein solcher Kontaktstift, der etwa durch einen Kontaktpin oder einen Litzendraht gebildet werden kann, durch Löten oder Schweißen mit dem Drahtgewebe mechanisch und elektrisch verbunden.

Zumindest eines der Drahtgewebe der Kontaktelemente 6, 7 ist in einer Köperbindung gewebt beziehungsweise geflochten. Der Vorteil einer Köperbindung stellt sich durch einen geringeren Maschenverbund beispielsweise im Vergleich zu einer Leinen- oder Leinwandbindung dar. Der Draht wird bei einer Köperbindung bereits beim Weben geringer belastet.

In Figur 2 ist weiterhin der Unterschied im Kraft-Dehnungsdiagramm zwischen Drahtgeweben, die auch als Siebe bezeichnet werden können, mit glatter Bindung, also einer Leinwandbindung, gegenüber Drahtgeweben mit Köperbindung gezeigt. Dabei sind der Dehnungsweg L in mm auf der horizontalen Achse und die aufzubringende Kraft F in N auf der vertikalen Achse aufgetragen. Die Kraft-Dehnungs-Kurven der Drahtgewebe mit einer glatten Bindung sind mit 11 und 12, die der Drahtgewebe mit Köperbindung mit 13 und 14 bezeichnet. Wie aus Figur 2 ersichtlich ist, ist die aufzubringende Kraft für einen Dehnungsweg von 5 mm bei einer Köper- im Vergleich zu einer glatten Bindung etwa 10mal geringer. Der lockere Maschenverbund zeigt sich somit elastischer.

Als besonders vorteilhaft erweist es sich im gezeigten Ausführungsbeispiel, wenn beide Drahtgewebe eine Köperbindung aufweisen.

Des Weiteren ist es besonders vorteilhaft, wenn zumindest eines der beiden Drahtgewebe oder auch beide wenigstens eines oder mehrere der folgenden Merkmale aufweist:
- einen Elastizitätsmodul von 200000 MPa,
- eine Zugfestigkeit von größer oder gleich 500 N/mm² und kleiner oder gleich 850 N/mm²,
- eine Streckgrenze von größer oder gleich 380 N/mm² und kleiner oder gleich 550 N/mm²,
- eine Bruchdehnung von größer oder gleich 30 % und kleiner oder gleich 35 %,
- einen thermischen Ausdehnungskoeffizienten von größer oder gleich 1,36·10⁻⁵ und kleiner oder gleich 1,60·10⁻⁵,
- eine Drahtstärke von größer oder gleich 0,03 mm und kleiner oder gleich 0,3 mm,
- eine Maschenweite von größer oder gleich 0,1 mm und kleiner oder gleich 0,3 mm,
- ein Verhältnis von Drahtstärke zu Maschenweite in einem Bereich zwischen 0,3 und 0,45.

Weiterhin liegt der Abstand jeweils zweier direkt zueinander benachbarter erster oder jeweils zweier direkt zueinander benachbarter zweiter Elektrodenschichten 2, 3 vorzugsweise in einem Bereich von 60 bis 65 µm und besonders bevorzugt bei etwa 62 µm.

Es ist darüber hinaus vorteilhaft, wenn das Verhältnis der Maschenweite zumindest eines Drahtgewebes zum Abstand jeweils zweier direkt zueinander benachbarter erster oder jeweils zweier direkt zueinander benachbarter zweiter Elektrodenschichten 2, 3 in einem Bereich zwischen 2,5 und 3,5 liegt.

Besonders vorteilhaft können insbesondere auch Kombinationen der vorgenannten Merkmale für zumindest eines oder beide Drahtgewebe sein. Unter anderem haben sich ein erstes und ein zweites Kontaktelement 6, 7 als besonders vorteilhaft erwiesen, die die im Folgenden als Ausführungsbeispiel A bezeichnete Merkmalskombination aufweisen, wobei dieses Ausführungsbeispiel nicht Gegenstand der Erfindung ist. Beide Kontaktelemente 6, 7 weisen ein Drahtgewebe in Köperbindung aus einem austenitischen nichtrostenden Stahl auf. Weiterhin weisen Drahtgewebe einen Elastizitätsmodul von 200000 MPa, eine Zugfestigkeit von größer oder gleich 500 N/mm² und kleiner oder gleich 700 N/mm² und eine Streckgrenze von 380 N/mm² auf. Die Bruchdehnung der Drahtgewebe der Kontaktelemente 6, 7 ist größer oder gleich 30 % und kleiner oder gleich 35 % und ihr thermischer Ausdehnungskoeffizient beträgt 1,60·10⁻⁵. Des Weiteren beträgt die Maschenweite der Drahtgewebe 0,18 mm und die Drahtstärke 0,056 mm.

In einem erfindungsgemäßen Ausführungsbeispiel, das im Folgenden als Ausführungsbeispiel B bezeichnet wird, weisen die Drahtgewebe der Kontaktelemente 6, 7 eine Nickel-Chrom-Legierung auf, wobei das Verhältnis von Nickel zu Chrom bei 80 zu 20 liegt. Die Drahtgewebe der Kontaktelemente 6, 7 weisen einen Elastizitätsmodul von 200000 MPa, eine Zugfestigkeit von größer oder gleich 650 N/mm² und kleiner oder gleich 850 N/mm² und eine Streckgrenze von 550 N/mm² auf. Die Bruchdehnung der Drahtgewebe der Kontaktelemente 6, 7 beträgt 30 % und der thermische Ausdehnungskoeffizient liegt bei 1,36·10⁻⁵. Die Maschenweite der Drahtgewebe der Kontaktelemente 6, 7 beträgt 0,18 mm und die Drahtstärke 0,080 mm.

Für den Nachweis der Zuverlässigkeit in der Anwendung der piezoelektrischen Vielschichtaktoren sind verschiedene energiegesteuerte Tests notwendig. Überlasttests werden üblicherweise bei einer Frequenz von 83 Hz und einer Temperatur von 80°C sowie einer Dehnung bis 2,4 % geführt.

Es wurde herausgefunden, dass die Verwendung eines üblichen Drahtmaterials, das im Vergleich zu den Drahtmaterialien der Ausführungsbeispiele A und B eine geringere Zugfestigkeit und eine geringere Bruchdehnung aufweist, zu einem Ausfall der piezoelektrischen Schichten ab 2·10⁸ Zyklen führen kann. Ein solcher Ausfall kann beispielsweise durch einen Längsriss in den piezoelektrischen Schichten zwischen zwei Sollbruchstellen im Bereich einer so genannten Isozone verursacht werden, wobei als Isozonen die Bereiche innerhalb des Stapels 1 bezeichnet werden, in dem sich die jeweils gegenüberliegenden ersten und zweiten Elektrodenschichten 2, 3 nicht überlappen.

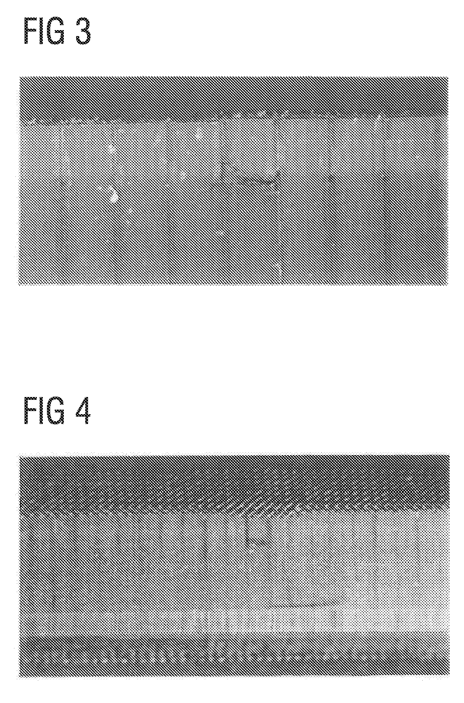

In den Figuren 3 und 4 sind derartige Ausfälle durch Schäden in den piezoelektrischen Schichten gezeigt. Der Ausfall wird bestimmt durch einen Abfall der Kapazität beziehungsweise der Auslenkung, da ein Stapelsegment kurzgeschlossen ist.

Im angesteuerten Temperaturwechseltest, bei dem ein Stapel aus piezoelektrischen Schichten, der mit einem üblichen Drahtgewebe aus einem Drahtmaterial kontaktiert ist das im Vergleich zu den Drahtmaterialien der Ausführungsbeispiele A und B eine geringere Zugfestigkeit und eine geringere Bruchdehnung aufweist, abwechselnd bei -40°C und +170°C bei einer Dehnung von mehr als 1,5 % betrieben wird, treten typischerweise bereits nach wenigen Temperaturzyklen als Fehlerursache Siebrisse auf.

Bei Zuverlässigkeitsmessungen von piezoelektrischen Vielschichtaktoren mit Stapeln 1, die ein erstes und zweites Kontaktelement 6, 7 mit jeweils einem Drahtgewebe gemäß Ausführungsbeispiel A als Metallverbund als Kontaktierung besaßen, traten keramische Fehler bis in den Zyklenbereich von 5·10⁸ nicht mehr in Erscheinung. Durch Erhöhung der Zugfestigkeit und Bruchdehnung können somit mit Vorteil Schädigungen an den piezoelektrischen Schichten des Stapels vermieden werden.

Die Ausfallsrate, jetzt hauptsächlich im Überlastbereich von mehr als 2,0 % erzeugt, wird höchstens noch durch Siebrisse bestimmt.

Die Kontaktierung mit einem Drahtgewebe gemäß dem Ausführungsbeispiel B, insbesondere die Erhöhung der Streckgrenze und Zugfestigkeit, hat sich bezüglich der Dauerhaltbarkeit als besonders vorteilhaft erwiesen. Dabei setzt das Drahtgewebe mit dem Drahtmaterial gemäß dem Ausführungsbeispiel B mit Vorteil auf den positiven Eigenschaften des Drahtgewebes gemäß Ausführungsbeispiel A auf.

Insbesondere konnte in Versuchen gezeigt werden, dass bei dem hier beschriebenen piezoelektrischen Vielschichtaktor Schädigungen der piezoelektrischen Schichten durch Risse vermieden werden können, was vor allem auf die erhöhte Bruchdehnung und die erhöhte Zugfestigkeit zurückzuführen ist.

Des Weiteren konnte gezeigt werden, dass durch eine Erweiterung des Dehnungsbereiches, in dem das Drahtmaterial reversibel auf Krafteinwirkung reagiert, Siebrisse vermieden werden können.

Die Erfindung ist nicht durch die Beschreibung an Hand der Ausführungsbeispiele auf diese beschränkt, sondern beinhaltet insbesondere jede Kombination von Merkmalen in den Patentansprüchen, auch wenn diese Kombination selbst nicht explizit in den Patentansprüchen oder Ausführungsbeispielen angegeben ist.

## Patentansprüche

1. Piezoelektrischer Vielschichtaktor (100)
- mit einem Stapel (1) aus übereinander angeordneten piezoelektrischen Schichten und dazwischen angeordneten ersten Elektrodenschichten (2) und zweiten Elektrodenschichten (3),
- wobei sich die ersten Elektrodenschichten (2) von einer ersten Seitenfläche (4) des Stapels (1) in den Stapel (1) hineinerstrecken und sich die zweiten Elektrodenschichten (3) von einer zweiten Seitenfläche (5) des Stapels (1) in den Stapel (1) hineinerstrecken,
- wobei sich die ersten Elektrodenschichten (2) und die zweiten Elektrodenschichten (3) im Stapel (1) überlappen,
- wobei auf der ersten Seitenfläche (4) ein erstes Kontaktelement (6) in elektrischem Kontakt mit den ersten Elektrodenschichten (2) und auf der zweiten Seitenfläche (5) ein zweites Kontaktelement (7) in elektrischem Kontakt mit den zweiten Elektrodenschichten (3) angeordnet ist,
- wobei das erste und das zweite Kontaktelement (6, 7) jeweils ein Drahtgewebe aufweisen,
- wobei zumindest ein Drahtgewebe eine Köperbindung aufweist
, **dadurch gekennzeichnet, dass** das zumindest eine Drahtgewebe eine Nickel-Chrom-Legierung mit einem Verhältnis von Nickel zu Chrom von 80 zu 20 aufweist.

2. Vielschichtaktor nach Anspruch 1,
- wobei das zumindest eine Drahtgewebe ein Material aufweist, welches eine Streckgrenze von größer oder gleich 380 N/mm² aufweist.

3. Vielschichtaktor nach einem der Ansprüche 1 oder 2,
- wobei das zumindest eine Drahtgewebe ein Material aufweist, welches eine Zugfestigkeit von größer oder gleich 500 N/mm² aufweist.

4. Vielschichtaktor nach einem der vorhergehenden Ansprüche,
- wobei das zumindest eine Drahtgewebe ein Material aufweist, welches eine Bruchdehnung von größer oder gleich 20% aufweist.

5. Vielschichtaktor nach einem der vorhergehenden Ansprüche,
- wobei das zumindest eine Drahtgewebe ein Material aufweist, welches einen thermischen Ausdehnungskoeffizienten von größer oder gleich 1,1·10⁻⁵ aufweist.

6. Vielschichtaktor nach einem der vorhergehenden Ansprüche,
- wobei das zumindest eine Drahtgewebe ein Material aufweist, welches ein Elastizitätsmodul von in etwa 200000 MPa aufweist.

7. Vielschichtaktor nach einem der vorhergehenden Ansprüche,
- wobei das zumindest eine Drahtgewebe eine Maschenweite von größer oder gleich 0,1 mm und kleiner oder gleich 0,3 mm aufweist.

8. Vielschichtaktor nach einem der vorhergehenden Ansprüche,
- wobei das zumindest eine Drahtgewebe ein Material aufweist, welches eine Drahtstärke von größer oder gleich 0,03 mm und kleiner oder gleich 0,3 mm aufweist.

9. Vielschichtaktor nach einem der vorhergehenden Ansprüche,
- wobei das zumindest eine Drahtgewebe ein Verhältnis von Drahtstärke zu Maschenweite in einem Bereich zwischen 0,3 und 0,45 aufweist.

10. Vielschichtaktor nach einem der vorhergehenden Ansprüche,
- wobei das zumindest eine Drahtgewebe eine Maschenweite aufweist und das Verhältnis der Maschenweite zu einem Abstand jeweils zweier direkt zueinander benachbarter erster (2) oder jeweils zweier direkt zueinander benachbarter zweiter (3) Elektrodenschichten in einem Bereich zwischen 2,5 und 3,5 liegt.

11. Vielschichtaktor nach einem der vorhergehenden Ansprüche,
- wobei das erste und das zweite Kontaktelement (6, 7) gleich ausgeführt sind.

12. Vielschichtaktor nach einem der vorhergehenden Ansprüche,
- wobei auf der ersten und zweiten Seitenfläche (4, 5) jeweils eine elektrische Kontaktschicht angeordnet ist,
- wobei das erste und das zweite Kontaktelement (6, 7) jeweils auf einer der elektrischen Kontaktschichten aufgelötet ist.

13. Vielschichtaktor nach einem der vorhergehenden Ansprüche,
- wobei ein Kontaktstift zur Weiterkontaktierung in das zumindest eine Drahtgewebe integriert ist.

## Claims

1. Piezoelectric multilayer actuator (100),
- comprising a stack (1) composed of piezoelectric layers arranged one above another and first electrode layers (2) and second electrode layers (3) arranged between said piezoelectric layers,
- wherein the first electrode layers (2) extend into the stack (1) from a first side area (4) of the stack (1) and the second electrode layers (3) extend into the stack (1) from a second side area (5) of the stack (1),
- wherein the first electrode layers (2) and the second electrode layers (3) overlap in the stack (1),
- wherein, on the first side area (4), a first contact element (6) is arranged in electrical contact with the first electrode layers (2) and, on the second side area (5), a second contact element (7) is arranged in electrical contact with the second electrode layers (3),
- wherein the first and second contact elements (6, 7) each have a wire fabric,
- wherein at least one wire fabric has a twill weave, **characterized in that** the at least one wire fabric comprises a nickel-chromium alloy having a ratio of nickel to chromium of 80 to 20.

2. Multilayer actuator according to Claim 1,
- wherein the at least one wire fabric comprises a material having a yield point of greater than or equal to 380 N/mm².

3. Multilayer actuator according to either of Claims 1 and 2,
- wherein the at least one wire fabric comprises a material having a tensile strength of greater than or equal to 500 N/mm².

4. Multilayer actuator according to any of the preceding claims,
- wherein the at least one wire fabric comprises a material having an elongation at break of greater than or equal to 20%.

5. Multilayer actuator according to any of the preceding claims,
- wherein the at least one wire fabric comprises a material having a coefficient of thermal expansion of greater than or equal to 1.1·10⁻⁵.

6. Multilayer actuator according to any of the preceding claims,
- wherein the at least one wire fabric comprises a material having a modulus of elasticity of approximately 200 000 MPa.

7. Multilayer actuator according to any of the preceding claims,
- wherein the at least one wire fabric has a mesh width of greater than or equal to 0.1 mm and less than or equal to 0.3 mm.

8. Multilayer actuator according to any of the preceding claims,
- wherein the at least one wire fabric comprises a material having a wire thickness of greater than or equal to 0.03 mm and less than or equal to 0.3 mm.

9. Multilayer actuator according to any of the preceding claims,
- wherein the at least one wire fabric has a ratio of wire thickness to mesh width in a range of between 0.3 and 0.45.

10. Multilayer actuator according to any of the preceding claims,
- wherein the at least one wire fabric has a mesh width and the ratio of the mesh width to a distance between in each case two first electrode layers (2) directly adjacent to one another or in each case two second electrode layers (3) directly adjacent to one another is in a range of between 2.5 and 3.5.

11. Multilayer actuator according to any of the preceding claims,
- wherein the first and second contact elements (6, 7) are embodied identically.

12. Multilayer actuator according to any of the preceding claims,
- wherein an electrical contact layer is in each case arranged on the first and second side areas (4, 5),
- wherein the first and second contact elements (6, 7) are in each case soldered on one of the electrical contact layers.

13. Multilayer actuator according to any of the preceding claims,
- wherein a contact pin for further contact-making is integrated into the at least one wire fabric.

## Revendications

1. Actionneur piézoélectrique multicouche (100),
présentant un empilement (1) constitué de couches piézoélectriques disposées les unes au-dessus des autres et entre lesquelles sont disposées des premières couches d'électrode (2) et des deuxièmes couches d'électrode (3),
les premières couches d'électrode (2) pénétrant dans l'empilement (1) depuis une première surface latérale (4) de l'empilement (1) et les deuxièmes couches d'électrode (3) pénétrant dans l'empilement (1) depuis une deuxième surface latérale (5) de l'empilement (1),
les premières couches d'électrode (2) et les deuxièmes couches d'électrode (3) se superposant dans l'empilement (1),
un premier élément de contact (6) étant disposé en contact électrique avec les premières couches d'électrode (2) sur la première surface latérale (4) et un deuxième élément de contact (7) étant disposé en contact électrique avec les deuxièmes couches d'électrode (3) sur la deuxième surface latérale (5),
le premier et le deuxième élément de contact (6, 7) présentant tous deux un tissu de fils,
au moins un tissu de fils présentant une armure croisée, **caractérisé en ce que**
le ou les tissus de fils présentent un alliage au nickel-chrome dont le rapport entre le nickel et le chrome est de 80 à 20.

2. Actionneur multicouche selon la revendication 1, dans lequel le ou les tissus de fils présentent un matériau dont la limite d'allongement est supérieure ou égale à 380 N/mm².

3. Actionneur multicouche selon l'une des revendications 1 ou 2, dans lequel le ou les tissus de fils présentent un matériau dont la résistance à la traction est supérieure ou égale à 500 N/mm².

4. Actionneur multicouche selon l'une des revendications précédentes, dans lequel le ou les tissus de fils présentent un matériau dont l'allongement à la rupture est supérieur ou égal à 20 %.

5. Actionneur multicouche selon l'une des revendications précédentes, dans lequel le ou les tissus de fils présentent un matériau dont le coefficient de dilatation thermique est supérieur ou égal à 1,1·10⁻⁵.

6. Actionneur multicouche selon l'une des revendications précédentes, dans lequel le ou les tissus de fils présentent un matériau dont le module d'élasticité est d'environ 200 000 MPa.

7. Actionneur multicouche selon l'une des revendications précédentes, dans lequel le ou les tissus de fils présentent une maille d'une taille supérieure ou égale à 0,1 mm et inférieure ou égale à 0,3 mm.

8. Actionneur multicouche selon l'une des revendications précédentes, dans lequel le ou les tissus de fils présentent un matériau dont l'épaisseur du fil est supérieure ou égale à 0,03 mm et inférieure ou égale à 0,3 mm.

9. Actionneur multicouche selon l'une des revendications précédentes, dans lequel le ou les tissus de fils présentent un rapport entre l'épaisseur du fil et la taille des mailles compris dans la plage de 0,3 à 0,45.

10. Actionneur multicouche selon l'une des revendications précédentes, dans lequel le ou les tissus de fils présentent une taille de maille et le rapport entre la taille de maille et la distance entre deux premières couches d'électrode (2) directement voisines l'une de l'autre ou deux deuxièmes couches d'électrode (3) directement voisines l'une de l'autre est compris dans la plage de 2,5 à 3,5.

11. Actionneur multicouche selon l'une des revendications précédentes, dans lequel le premier et le deuxième élément de contact (6, 7) sont réalisés de manière identique.

12. Actionneur multicouche selon l'une des revendications précédentes, dans lequel une couche de contact électrique est disposée sur la première et la deuxième surface latérale (4, 5), le premier et le deuxième élément de contact (6, 7) étant brasé sur une couche de contact électrique respective.

13. Actionneur multicouche selon l'une des revendications précédentes, dans lequel une tige de contact permettant de prolonger le contact est intégrée dans le ou les tissus de fils.
